# EUROPÄISCHE PATENTSCHRIFT

(11) **EP 0 503 577 B1**
(45) Veröffentlichungstag und Bekanntmachung des Hinweises auf die Patenterteilung: **19.06.1996**
(21) Anmeldenummer: 92104118.2
(22) Anmeldetag: 11.03.1992
(51) Int. Cl.: C23C 14/34

(54) **Verfahren zur Herstellung dünner Schichten und Vorrichtung**
Method for the production of thin films and apparatus therefor
Procédé pour la préparation de couches minces et dispositif

(30) Priorität: 13.03.1991 DE 4108001
(43) Veröffentlichungstag der Anmeldung: 16.09.1992
(73) Patentinhaber: FORSCHUNGSZENTRUM JÜLICH GMBH, D-52425 Jülich (DE)
(72) Erfinder: Wördenweber, Roger, Dr., W-5162 Niederzier (DE)

(56) Entgegenhaltungen:
- DE-A- 3 805 010
- DE-C- 3 809 734
- US-A- 4 692 230

## Beschreibung

Die Erfindung bezieht sich auf ein Verfahren zur Herstellung dünner Schichten aus Materialien, die Sauerstoff oder andere reaktive Komponenten enthalten, wie beispielsweise das Material eines oxidischen Hochtemperatur-Supraleiters, bei dem das Material als Target- bzw. Kathoden-Material eingesetzt und die Schicht durch Kathodenzerstäubung auf einem erhitzten Substrat durch Niederschlag gebildet wird. Die Erfindung bezieht sich ferner auf eine Vorrichtung zur Herstellung dünner Schichten aus Materialien, die Sauerstoff oder andere reaktive Komponenten enthalten, wie beispielsweise das Material eines oxidischen Hochtemperatur-Supraleiters, die aus in einer gasdichten Kammer angeordneter Kathoden-und Anoden-Anordnung mit wenigstens einer Kathode, Kathodenmaterial als Target und einem beheizbaren Substrathalter besteht, bei der die Kammer außerdem Gaszuleitung und eine Absaugeinrichtung aufweist. Ein derartiges Verfahren bzw. ein derartige Vorrichtung ist aus DE-C-38 09 734 bekannt.

Zu der Klasse von Verbindungen, die z.B. Sauerstoff oder Stickstoff enthalten, zählen z.B. Hochtemperatur-Supraleiter (z.B. YBa₂Cu₃D₇₋ₓ, Bi-Sr-Ca-Cu-O und Tl-Ba-Ca-Cu-O), die sich durch eine recht komplizierte Struktur (Perowskit-Struktur) und in-situ eingebauten Sauerstoff auszeichnen.

Als bekannte Verfahren der eingangs bezeichneten Art sind zu nennen das allgemein bekannte planare bzw. aus z.B. X.X. Xi, G. Linker, 0. Meyer, E. Nold, B. Obst, F. Ratzel, R. Smithey, B. Strehlau, F. Weschenfelder, und J. Geerk, Z. Phys. B 74 (1989), 13 oder C.B. Eom, J.Z. Sun, K. Yamamoto, A.F. Marshall, K.E. Luther, T.H. Geballe und S.S. Laderman, Appl. Phys. Lett. 55 (1989), S. 595., bekannte "off axis" Hochdruckkathodenzerstäubung. Daneben gibt es andere Abscheidungsverfahren wie z.B. Verdampfung, Laserablation, elektrolytische Verfahren usw. die jedoch bei tiefen Drücken durchgeführt werden.

Wie z.B. aus L.R. Gilbert, R. Messier und S.V. Krishnaswamy, J. Vac. Sci. Technol. 17, (1980), S. 389, als sogenannte Rücksputtereffekte bekannt, wird nachteilig die nach der bekannten Kathodenzerstäubungsmethode aufgetragene Schicht durch Ionen aus dem Plasma wieder abgetragen. Außerdem zeigen sich bei diesen Zerstäubungsmethoden ungewollte und nachteilige Aufladungseffekte.

Es ist Aufgabe der Erfindung, ein Verfahren zu schaffen, bei dem nachteilige Effekte wie beispielsweise Effekte, wobei die hergestellte Schicht durch Ionen aus dem Plasma wieder abgetragen wird (Rücksputtereffekt) oder Aufladungseffekte nicht auftreten. Aufgabe der Erfindung ist ferner eine zur Durchführung des Verfahrens geeignete Vorrichtung.

Diese Aufgabe wird erfindungsgemäß bei einem Verfahren der eingangs bezeichneten Art dadurch gelöst, daß vom Target abgelöste Teilchen außerhalb des bei der Kathodenzerstäubung entstehenden Plasmas nur durch den Strom eines Gases mit einem Druck von 10 Pa bis 2000 Pa (0,1 bis 20 mbar)zu dem zu beschichtenden, vom Target räumlich getrennten Substrat transportiert wird. Ein optimaler Druckbereich beträgt 50 Pa bis 1000 Pa (0,5 bis 10 mbar).

Die Vorteile des erfindungsgemäßen Verfahrens sind folgende:
(i) Das erfindungsgemäße Verfahren vermeidet nachteilige Effekte des sich am Target bildenden Plasmas für die aufwachsende Schicht. Dies sind z.B. die vorher erwähnten Abtragungseffekte (bei der Abscheidung (Deposition) von YBa₂Cu₃O₇₋ₓ durch die Sauerstoffionen und Elektronen des Plasmas), Aufladungseffekte und Aufheizen des Substrates. (ii) Gegenüber den CVD-Verfahren (Chemical vapour deposition), die ja auch mit einer räumlichen Trennung von Quelle und Substrat und mit einem Teilchentransport durch Gasfluß arbeiten, bietet dieses Verfahren den Vorteil, daß die abzuscheidenden Teilchen zum einen auf eine wesentlich einfachere Art und Weise angeboten werden (für die CVD-Abscheidung von YBa₂Cu₃O_{*7-*}ₓ ist z.B. der Schichtdickenwachstum pro Zeit (Wachstumsrate) sehr schwer stabilisierbar), zum anderen sind keine Trägersubstanzen nötig, die beim CVD ungewünschter Weise eingebaut werden könnten (z.B. Kohlenstoff). Das CVD-Verfahren ist außerdem wesentlich teurer. (iii) Generell kann durch die räumliche Trennung von Quelle (mit Plasma) und Substrat eine in-situ Analyse und Korrektur der integralen Stüchiometrie der "anfliegenden" Teilchen vorgenommen werden (durch eine Sonde bzw. durch Spektralanalyse). Dies ist ebenfalls bei den CVD-Verfahren möglich, wobei dort jedoch das Trägermaterial mitgemessen wird.

Die erfindungsgemäße Vorrichtung ist dadurch gekennzeichnet, daß der Substrathalter seitlich der Flächennormale des Targets um wenigstens das Eineinhalbfache der Flächenausdehnung des Targets (in Richtung des Substrathalters) versetzt angeordnet ist und daß Kathode, Substrathalter, Gaszuleitung und Absaugöffnung zueinander so angeordnet sind, daß bei Betrieb der Vorrichtung ein Gasstrom von der Kathode bzw. vom Bereich des entstehenden Plasmas zum Substrathalter gelangt.

Bei einer vorteilhaften Ausführungsform der Vorrichtung sind mehrere, zueinander sternförmig angeordnete Targets vorgesehen, was auf einfache Weise das Mischen unterschiedlicher Materialien erlaubt.

Es kann auch zweckmäßig sein, Gastromführungen, wie Leitbleche oder Schikanen zur Ausrichtung des Gasstromes vorzusehen.

Eine vorteilhafte Ausführungsform der Vorrichtung gemäß der Erfindung besteht außerdem darin, daß die Kammer einen im Gasstrom gelegenen, zwischen Kathodenmaterial und Substrathalter angeordneten Analysenbereich für die Untersuchung der Zusammensetzung der im Gasstrom mitgeführten Teilchen aufweist.

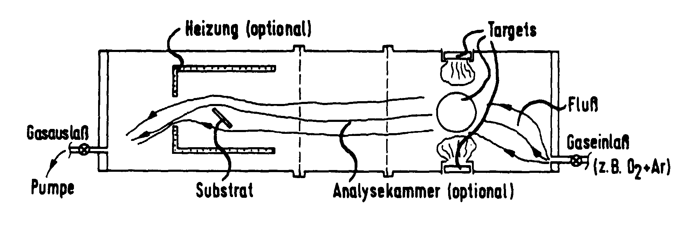

Das erfindungsgemäße Verfahren wird anhand der beiliegenden Zeichnung beschrieben. Die Vorrichtung besteht aus drei Teilen.

In der rechten Kammer befinden sich (z.B. sternförmig angeordnet) die Kathoden, auf denen Targetmaterial mit den entsprechenden Elementen bzw. Legierungen angebracht wird. Nach Zünden des Plasmas wird nun abhängig von der anliegenden Leistung von den unterschiedlichen Targets Material abgetragen. Der hohe Hintergrundsdruck von ca. 0,1 - 20 mbar sorgt nun für eine extrem kleine frei Weglänge von 2 - 200 µm. Bei 50 Pa bis 1000 Pa (0,5 - 10 mbar) liegt die freie Weglänge bei ca. 10 - 100 µm. Es wird nun ein ausreichender Gasstrom (siehe Skizze) realisiert, der nun die Teilchenbewegung beeinflußt und sie in Richtung des Substrates lenkt.

Es kann nun eine Analyseeinheit zwischen Kathode und Substrat eingebaut werden. Hierfür bieten sich Sonden bzw. Analyse des Energiespektrums (z.B. durch Röntgenstrahlung angeregt) der Teilchen an. Die elementspezifische quantitative Bestimmung der anfliegenden Teilchen kann nun zur Regelung der Kathoden benutzt werden, so daß die Stöchiometrie der aufwachsenden Schicht in-situ kontrolliert und korrigiert werden kann. Dies ist z.B. für mehrkomponentige Zusammensetzungen wie z.B. YBa₂Cu₃O₇₋ₓ oder auch Bi₂Sr₂Ca₂Cu₂O_{y} oder Bi₂Sr₂Ca₂Cu₁O_{y} von entscheidender Bedeutung.

In der linken Kammer findet nun die eigentliche Abscheidung statt. Hier kann das oder auch mehrere Substrate im Gasstrom positioniert werden. Vorteile zeichnen sich für die großflächige Beschichtung und die definierte Temperaturregelung (z.B. für YBa₂Cu₃O₇₋ₓ von entscheidender Bedeutung) ab. Letzteres ist z.B. durch die Anwesenheit des Plasmas bei der planaren Kathodenzerstäubung extrem schwierig. In der Skizze ist eine Heizmöglichkeit angedeutet, die dadurch, daß sie die Probe besser umschließt als bei den anderen Verfahren zu einer besseren Temperaturdefinition am Substrat führen würde. Die Ablagerung von Material an der Rezipientenwand kann durch geeignete Führung der Strömung und/bzw. Aufheizung der Wände reduziert und evtl. sogar vermieden werden.

Vergleich mit anderen Dünnschichtdepositionsverfahren:
1.) Planare Hochdruckkathodenzerstäubung: Dieses Verfahren besitzt wie oben angegeben den gravierenden Nachteil, daß das Substrat im Plasma bzw. dicht am Plasma positioniert ist, so daß Abtragungseffekte (Folge: evtl. chemische Zersetzung) und Aufwärmung auftreten können. Desweiteren ist eine direkte Analyse des ankommenden Materials nicht möglich.
2.) "Off-Axis" Kathodenzerstäubung: Diese Methode wird insbesondere bei der Herstellung der Hochtemperatursupraleiter gerne angewandt. Bei der in Betracht zu ziehenden Hochdruckvarianten sind die kleineren Homogenitätsbereiche für die Abscheidung nachteilig. Eine in-situ Analyse ist ebenfalls nicht möglich. Kathodenzerstäubung von mehreren Targets und somit eine Korrektor der Zusammenstellung ist nicht möglich. Dies erschwert insbesondere die Herstellung von Filmen mit Zusammensetzungen, die sich nicht in einem Target anbieten lassen.
3.) Hohlkathodenzerstäubung: Analog zu 2.)
4.) Aufdampfen: Die meisten Aufdampfverfahren arbeiten bei niedrigen Drücken, daher ist das Einbauen von z.B. ausreichendem Sauerstoff in YBa₂Cu₃O₇₋ₓ extrem schwierig. Ausnahme, die Laserablation. Desweiteren werden beim Aufdampfen größere Teilchen freigesetzt, was meist zu schlechteren Schichtqualitäten führt.

## Patentansprüche

1. Verfahren geeignet zur Herstellung dünner Schichten aus Materialien, die in hohem Maße Sauerstoff oder andere reaktive Gase enthalten, wie beispielsweise das Material eines oxidischen Hochtemperatur-Supraleiters, bei dem das Material als Target- bzw. Kathoden-Material eingesetzt und die Schicht durch Kathodenzerstäubung auf einem vom Target räumlich getrennten Substrat durch Niederschlag gebildet wird,
wobei die vom Target abgelöste Teilchen außerhalb des bei der Kathodenzerstäubung entstehenden Plasmas in einem Gasstrom in Richtung des Substrats mitgeführt werden,
**dadurch gekennzeichnet**,
daß das Gas einen Druck von 10 Pa bis 2000 Pa (0,1 bis 20 mbar) hat, die Teilchen nur durch den Gasstrom zum Substrat transportiert werden und das Substrat erhitzt wird.

2. Verfahren nach Anspruch 1,
**dadurch gekennzeichnet**,
daß der Gasdruck 50 Pa bis 1000 Pa (0,5 bis 10 mbar) beträgt.

3. Vorrichtung geeignet zur Herstellung dünner Schichten aus Materialien, die in hohem Maße Sauerstoff oder andere reaktive Gase enthalten, wie beispielsweise das Material eines oxidischen Hochtemperatur-Supraleiters, die aus in einer gasdichten Kammer angeordneter Kathoden- und Anoden-Anordnung mit wenigstens einer Kathode, Kathodenmaterial als Target und einem beheizbaren Substrathalter besteht, bei der die Kammer außerdem Gaszuleitung und eine Absaugeinrichtung aufweist, wobei der Substrathalter seitlich der Flächennormalen des Targets um wenigstens das Eineinhalbfache der Flächenausdehnung des Targets in Richtung des Substrathalters versetzt angeordnet ist,
**dadurch gekennzeichnet**,
daß Kathode, Substrathalter, Gaszuleitung und Absaugöffnung zueinander so angeordnet sind, daß bei Betrieb der Vorrichtung ein Gasstrom von der Kathode bzw. vom Bereich des entstehenden Plasmas zum Substrathalter gelangt.

4. Vorrichtung nach Anspruch 3,
**dadurch gekennzeichnet**,
daß mehrere, zueinander sternförmig angeordnete Targets vorgesehen sind.

5. Vorrichtung nach einem der Ansprüche 3 und 4,
**dadurch gekennzeichnet**,
daß Gasstromführungen, wie Leitbleche, zur Ausrichtung des Gasstromes vorgesehen sind.

6. Vorrichtung nach einem der Ansprüche 3, 4 und 5,
**dadurch gekennzeichnet**,
daß die Kammer einen im Gasstrom gelegenen, zwischen Kathodenmaterial und Substrathalter angeordneten Analysenbereich für die Untersuchung der Zusammensetzung der im Gasstrom mitgeführten Teilchen aufweist.

## Claims

1. a process suitable for producing thin films of materials which contain a large proportion of oxygen or other reactive gases, such as the material of an oxidic high-temperature superconductor for example, in which the material is used as a target or cathode material and the film is formed by deposition by cathode sputtering on a substrate spatially separated from the target, wherein the particles removed from the target are entrained towards the substrate in a gas stream outside the plasma produced during cathode sputtering,
characterised in that the gas is at a pressure of 10 Pa to 2000 Pa (0.1 to 20 mbar), the particles are only transported to the substrate by the gas stream and the substrate is heated.

2. A process according to claim 1,
characterised in that the gas pressure is 50 Pa to 1000 Pa (0.5 to 10 mbar).

3. An apparatus suitable for producing thin films of materials which contain a large proportion of oxygen or other reactive gases, such as the material of an oxidic high-temperature superconductor for example, which consists of a cathode and anode arrangement disposed in a gas-tight chamber and having at least one cathode, cathode material as a target and a heatable substrate holder, wherein the chamber additionally has a gas inlet and an extraction device, wherein the substrate holder is disposed offset laterally from the normal to the face of the target by at least one and a half times the superficial extent of the target in the direction of the substrate holder,
characterised in that the cathode, substrate holder, gas inlet and extraction opening are disposed in relation to each other so that when the apparatus is operated a gas stream reaches from the cathode or from the region of the plasma produced to the substrate holder.

4. An apparatus according to claim 3,
characterised in that a plurality of targets is provided, which are arranged in relation to each other in the form of a star.

5. An apparatus according to either one of claims 3 or 4,
characterised in that gas stream guides such as baffle plates are provided for aligning the gas stream.

6. An apparatus according to any one of claims 3, 4 or 5,
characterised in that the chamber comprises an analysis region for investigating the composition of the particles entrained in the gas stream, which analysis region is placed in the gas stream between the cathode material and the substrate holder.

## Revendications

1. Procédé adapté à la fabrication de couches minces en des matériaux qui contiennent dans une grande proportion de l'oxygène ou d'autres gaz réactifs, comme par exemple le matériau d'un supraconducteur à haute température obtenu par oxydation, dans lequel le matériau est utilisé comme matériau cible et de cathode et la couche formée par dépôt, par pulvérisation cathodique, sur un substrat chauffé,
des particules détachées de la cible à l'extérieur du plasma, créé lors de la pulvérisation cathodique, étant entraînées vers le substrat par un courant de gaz,
caractérisé en ce que le courant de gaz a une pression de 10 à 2000 Pa (0,1 à 20 mbar), en ce que les particules ne sont entraînées vers le substrat que par le courant de gaz et en ce que le substrat est chauffé.

2. Procédé suivant la revendication 1, caractérisé en ce que la pression du gaz est dans un intervalle compris entre 50 Pa et 1000 Pa (0,5 à 10 mbar).

3. Dispositif adapté à la fabrication de couches minces en des matériaux contenant en grande proportion de l'oxygène ou d'autres gaz réactifs, comme par exemple le matériau d'un supraconducteur à haute température obtenu par oxydation, qui est constitué d'un dispositif d'anodes et de cathodes prévu dans une chambre étanche au gaz et comportant au moins une cathode, d'un matériau cathodique en tant que cible et d'un support de substrat pouvant être chauffé, dans lequel la chambre comporte en outre une amenée de gaz et un dispositif d'aspiration, le support du substrat étant décalé, latéralement à la normale à la surface de la cible, d'au moins une fois et demi l'étendue de la surface de la cible en direction du support du substrat, caractérisé en ce que la cathode, le support du substrat, l'amenée de gaz et l'ouverture d'aspiration sont disposés les uns par rapport aux autres de manière que, lorsque le dispositif fonctionne, un courant de gaz parvient de la cathode et de la région du plasma qui se crée au support du substrat.

4. Dispositif suivant la revendication 3, caractérisé en ce qu'il est prévu plusieurs cibles disposées en étoile les unes par rapport aux autres.

5. Dispositif suivant l'une des revendications 3 et 4,
caractérisé en ce que des conduites du courant de gaz, comme des tôles de guidage, sont prévues pour orienter le courant de gaz.

6. Dispositif suivant l'une des revendications 3, 4 et 5, caractérisé en ce que la chambre comporte une région d'analyse, placée dans le courant de gaz, entre la matériau cathodique et le support du substrat, pour l'analyse de la composition des particules entraînées dans le courant de gaz.
